# EUROPEAN PATENT APPLICATION

(11) **EP 4 738 012 A1**
(43) Date of publication of application: **06.05.2026**
(21) Application number: 24210344.8
(22) Date of filing: 01.11.2024
(51) Int. Cl.: G03F 7/20, H01L 21/60, H01L 21/98

(54) **METHOD OF LITHOGRAPHY ON A RECONSTITUTED SUBSTRATE WITH POSITIONAL CORRECTION**

(71) Applicant: ASML Netherlands B.V., 5500 AH Veldhoven (NL)
(72) Inventor: SELEN, Jori, 5500 AH Veldhoven (NL); WERKMAN, Roy, 5500 AH Veldhoven (NL); HAUPTMANN, Marc, 5500 AH Veldhoven (NL)
(74) Representative: ASML Netherlands B.V.

(57) **Abstract**

Disclosed is a method of determining a correction for performing a lithographic exposure on a reconstituted substrate, said reconstituted substrate comprising a base substrate with a plurality of substrate portions bonded thereto, said substrate portions having been diced from one or more pre-diced substrates The method comprises: obtaining positional data describing a position of features in at least an uppermost layer of said one or more pre-diced substrates; and using said positional data to determine said correction for performing the lithographic exposure on the reconstituted substrate.

## Description

### BACKGROUND

### Field of the Invention

The present invention relates to a method and apparatus for lithography and in particular to lithography on a reconstituted substrate having been the subject of a die-to-wafer bonding process.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer.

In die-to-wafer bonding, individual dies or chiplets are bonded to an acceptor wafer or substrate (i.e., a base patterned substrate). A wafer reconstitution (or wafer reconstruction) may then be performed, comprising one or more processing steps to, for example, fill in gaps between the individual dies. The reconstituted wafer undergoes one or more further lithography processes (patterning steps), e.g., to form connections between patterns on the individual dies and patterns on the reconstituted wafer (and/or other individual dies).

It is desirable to improve lithography processes on reconstituted wafers in the manufacture of integrated devices.

### SUMMARY OF THE INVENTION

In a first aspect of the invention, there is provided a method of determining a correction for performing a lithographic exposure on a reconstituted substrate, said reconstituted substrate comprising a base substrate with a plurality of substrate portions bonded thereto, said substrate portions having been diced from one or more pre-diced substrates; the method comprising: obtaining positional data describing a position of features in at least an uppermost layer of said one or more pre-diced substrates; and using said positional data to determine said correction for performing the lithographic exposure on the reconstituted substrate.

In other aspects of the invention, there is provided a computer program operable to perform the method the first aspect and a substrate obtained by performing the method of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts a lithographic apparatus together with other apparatuses forming a production facility for semiconductor devices;
- Figure 2 illustrates a die-to-wafer bonding process; and
- Figure 3(a) illustrates a step of a feed-forward positional data method usable in a die-to-wafer bonding according to concepts disclosed herein;
- Figure 3(b) illustrates an alignment metrology strategy for measuring bonded dies on a reconstituted wafer according to concepts disclosed herein; and
- Figure 3(c) illustrates an in-plane deformation determination step for a reconstituted wafer according to concepts disclosed herein.

### DETAILED DESCRIPTION

Before describing embodiments of the invention in detail, it is instructive to present an example environment in which embodiments of the present invention may be implemented.

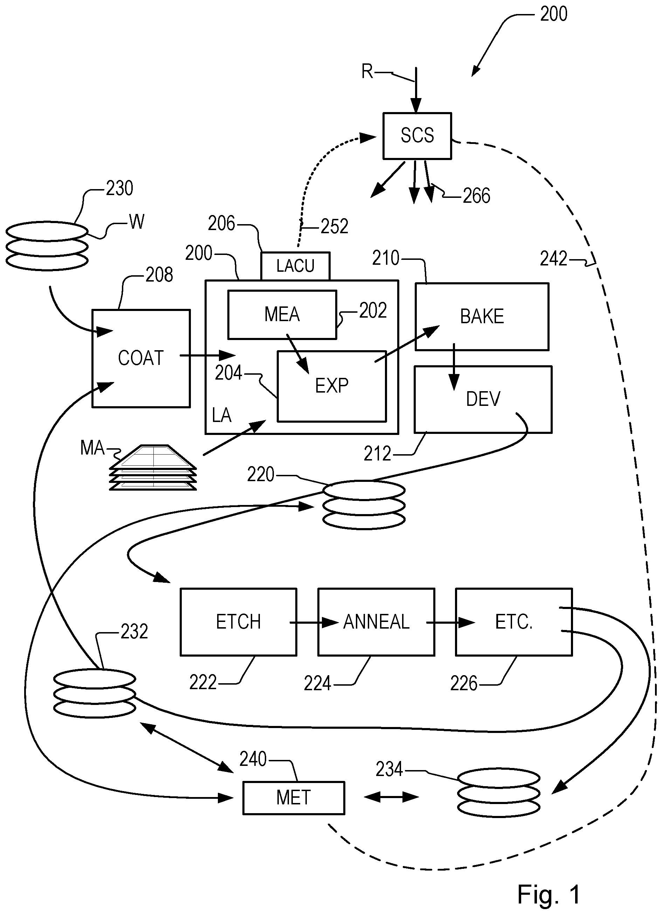

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. Note that the term wafer and substrate (at least within the context of a semiconductor substrate onto which a pattern is transferred in a lithography step) are used synonymously herein. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and substrate optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Die-to-Wafer comprises using a bonding tool to bond a number of individual substrate portions or dies to an acceptor or base substrate (or wafer), e.g., to provide a heterogeneous 3D integration of the individual dies onto the substrate. The dies, for example, may have multiple different data processing and/or storage functionalities and different dimensions.

Recent technology trends include the processing of so-called reconstituted wafers. Reconstituted wafers typically comprise a patterned base or acceptor substrate with multiple dies bonded thereon, after which the gaps in between the dies are filled with a material (e.g., oxide or oxynitride material). A subsequent process of flattening and cleaning prepares the reconstituted wafers for further wafer-level patterning. The further wafer-level patterning may comprise, for example, patterning of through-silicon-vias (TSVs), re-distribution layers (RDLs) and/or other functional structures. This patterning is executed using lithography equipment, e.g., a scanner or lithographic apparatus used for patterning conventional wafers. This may comprise the patterning of one or more layers, with additional processing steps (deposition, etch etc.) such as illustrated in Figure 1.

As such, the manufacture of a reconstituted wafer may comprise the use of *inter alia* one or more lithographic apparatuses to pattern the acceptor wafer (base patterned wafer) and one or more other wafers (pre-diced wafers) from which the individual to-be-bonded dies are cut, and a bonding tool to bond the dies to the acceptor wafer.

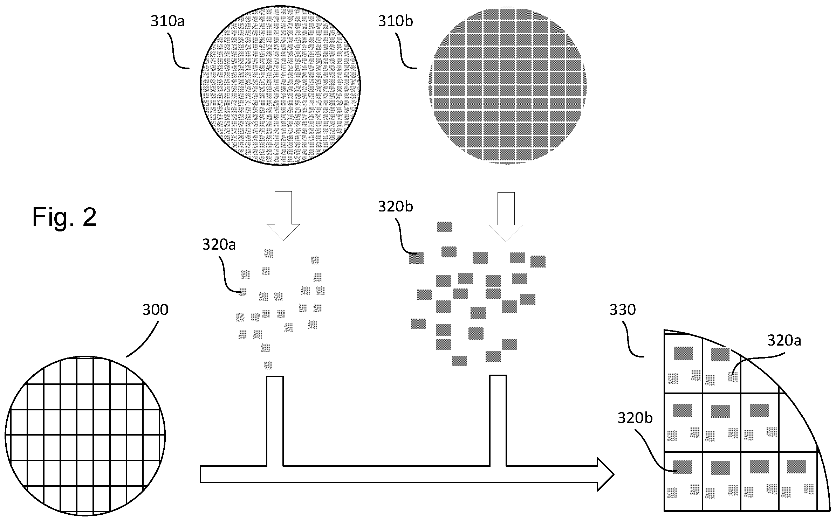

Figure 2 illustrates the basic concept of manufacturing a reconstructed wafer. The acceptor wafer or base patterned wafer (base substrate) 300 has been patterned in one or more lithographic steps, and further processed (e.g., etched etc.) in one or more processing steps, as part of an integrated circuit (IC) manufacturing process (e.g., such as illustrated in Figure 1). This patterning and processing may have formed multiple layers onto the wafer as is well known in IC manufacture. Similarly, one or more pre-diced wafers (pre-diced substrates) 3 10a, 310b are manufactured in a similar manner (although with different patterns/product) as the base patterned wafer 300. In this specific example, two pre-diced wafer types 310a, 310b are produced, each comprising multiple repetitions of a respective different circuit. Pre-diced wafers 310a, 310b are then diced to produce individual substrate portions or dies 320a, 320b. These individual dies 320a, 320b are then bonded to the base patterned wafer 300 to produce a die-to-wafer bonded wafer 330 (only a portion of which is shown). The number of individual dies 320a, 320b (and/or number of different types of dies) bonded to the base patterned wafer 300 may vary from shown here. For example, each field and/or die of the base patterned wafer 300 may have bonded thereto one or more dies respectively of one or more different die types. The bonded wafer 330 may undergo additional processing steps (e.g., *inter alia* to fill gaps between the bonded dies) to form a reconstituted wafer. Subsequently additional lithography steps are performed on the reconstituted wafer as has been described.

The additional lithography steps performed on the reconstituted wafer for one or more layers which need to align to the top layer of the reconstituted wafer. Therefore, the position of features on this top layer needs to be known with sufficient accuracy to form functional bonded dies. However, this is more difficult than for a conventional wafer. The reasons for this are fourfold:
1) The pre-diced wafers, and therefore the dies cut therefrom, have respective different edge placement and overlay errors. These dies will maintain these errors when bonded to the base patterned wafer.
2) The dies may originate from different pre-diced wafers and from different locations within those pre-diced wafers. For example, for the same bonding location on two or more reconstituted wafers, there may be wafer-to-wafer variation in the respective location within the pre-diced wafer from which the die being bonded was cut. This may be the case, for example, when a die on a pre-diced wafer does not yield and another die is used in its place or when not all the dies of a pre-diced wafer are bonded to the same base patterned wafer.
3) The bonding tool which is used for the die-to-wafer bonding does not place dies on the base patterned wafer with perfect accuracy. Each die bonded on a base patterned wafer will have a different respective bonding placement error.
4) The process of die-to-wafer bonding warps both the dies and the complete reconstituted wafer, inducing displacements of features on the top layer (additional to those described at reason 1) above).

A consequence of these factors is that displacements of the top layer of the reconstituted wafer are likely to be discontinuous across-wafer (i.e., between fields and dies) and are also likely to vary wafer-to-wafer for the reconstituted wafers.

Because of this, accurate positioning and overlay control of the subsequent patterning on the reconstituted wafer presently requires every individual die to be measured individually with dense alignment metrology to properly characterize the discontinuous positional errors. This is slow, meaning that throughput is relatively low making the technology less cost-effective. The methods disclosed herein enable acceptable performance with sparser alignment metrology, e.g., comprising measuring only three or four locations per bonded die (e.g., in addition to some locations on the base wafer).

More specifically, to address the issues listed 1) to 4), a feed-forward of positional data is proposed, which feeds forward at least positional data from the one or more pre-diced wafers from which one or more individual dies (substrate portions) are diced, for use when exposing at least one layer onto a reconstructed wafer comprising a base substrate onto which said one or more individual dies are bonded. The positional data may comprise any suitable data describing the position of features on the pre-diced substrates, such as overlay and/or alignment data or top layer displacement data derived from overlay and alignment data (or directly measured e.g., using a scanning electron microscope or any other metrology device able to measure top layer displacement directly).

The proposed positional data feed-forward may be implemented into a metrology framework comprising four aspects which respectively address each of the numbered fourfold issues described above in turn. The first aspect may be addressed by the aforementioned feedforward of feature positional data from the pre-diced wafers such as overlay and alignment data or the difference between overlay and alignment data. More specifically, top layer feature displacement data, describing displacement of features on the top layer of the pre-diced wafer (i.e., prior to dicing), may be determined from a comparison of (e.g., the difference between) overlay data with respect to a reference layer (any lower layer) and alignment data of the reference layer.

This displacement data may be measured per pre-diced wafer. However, per wafer metrology may be impractical due to speed constraints, in such a case the displacement data forwarded for unmeasured wafers may be representative displacement data which is representative of the measured wafers (e.g., of the same lot or other wafer grouping). For example, the representative displacement data may comprise the average displacement data of the measured wafers (i.e., the average wafer) per lot. Of course, representative or averaged displacement data may be forwarded and used for all of the pre-diced wafers, although better performance is to be expected (in many cases at no additional metrology cost) by forwarding the measured displacement data from the measured wafers.

In a specific example, the positional data that is fed forward may be obtained with no additional metrology overhead. Instead, the fed-forward metrology data may comprise only alignment data and overlay data which has been measured as part of the normal patterning control process for patterning the pre-diced wafers. This fed-forward positional data is used to determining a correction for performing a lithographic exposure on the reconstituted substrate.

The second aspect described above may be addressed by individually tracking each die after dicing with its associated displacements, such that respective displacement data for each bonded die is known after bonding to the reconstituted wafer. For example, each individual die may be given a unique identification which is stored with its positional data.

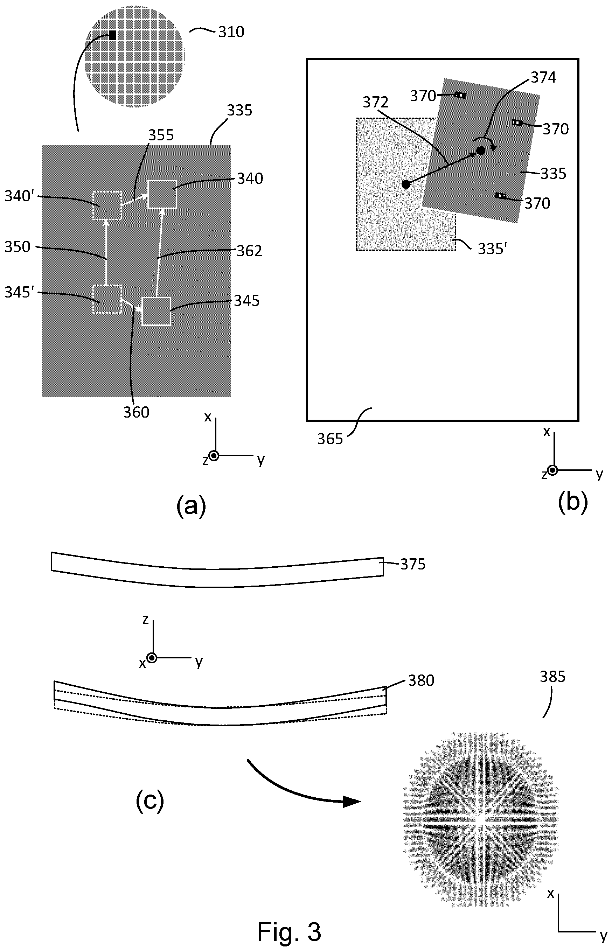

Figure 3(a) illustrates these concepts. Figure 3(a) shows a specific die 335 which has been diced from a pre-diced wafer 310. The die 335 comprises a top feature 340 and a bottom feature 345, and their intended positions 340', 345'. The nominal difference in position between the top feature 340 and bottom feature 345 is signified by arrow 350. Arrows 355, 360 signifies the displacement error of the top feature 340 and bottom feature 345 with respect to their respective intended position 340'. 345'. The actual difference in position between top feature 340 and bottom feature 345 is signified by arrow 362. This individual die, and its corresponding positional (e.g., displacement error) data, is tracked, e.g., by providing the die with an identifier label. When bonded to form a reconstituted wafer, the positional data specific to each bonded die (i.e., per-substrate portion position data) is known and can be used for determining positional corrections for exposing one or more subsequent layers on the reconstituted wafer.

The displacements introduced by bonding described by aspects 3) and 4) can then be addressed as follows. Sparse metrology may be performed on each of the bonded dies post-bonding to obtain reconstituted substrate alignment data. Such sparse metrology may measure, for example, no more than ten, no more than eight or no more than six (e.g., three or four) locations for each bonded die (or at least more than half of the bonded dies), although this does not preclude the fact that additional locations on the base wafer may also be measured. A measurement location may comprise a specific alignment mark or other structure on which alignment can be measured. The errors introduced by aspect 3) can be corrected using reconstituted substrate alignment data from two locations per bonded die (sufficient for determining displacement x/y and rotation around z of each bonded die); i.e., to determine a placement error correction. Aspect 4) can be partly addressed by the provision of additional reconstituted substrate alignment data from the other one or two (or more) locations per die, thereby providing sufficient datapoints to characterize higher order deformation of each die induced by the bonding process. Preferably, locations (mark placement) for at least some of the locations per die may be varied die-to-die across the reconstituted wafer. This enables determination of higher-order displacements of the average die, which can be used to determine a distortion correction for the distortion induced by the bonding process.

Figure 3(b) illustrates this concept. The die 335 position is shown with respect to a nominal die position 335' with a field 365 of the base patterned wafer. The die 335 comprises three alignment marks 370 which enables characterization of displacement 372 and rotation 374 positional error of the die 335 with respect to the base patterned wafer, and some higher order deformation content of each die induced by the bonding process.

To further address aspect 4), in-plane displacement data may be determined from wafer shape data (substrate shape data). For example, a difference in free-form wafer shape of the base patterned wafer and the free-form wafer shape of the reconstituted wafer may be determined, e.g., to characterize the bonding induced wafer warp, and translated to in-plane displacements using known models such as the Stoney model (or an appropriate die-aware extension). Such wafer shape metrology and in-plane displacement modeling are known in lithographic processing and will not be described further here.

This concept is illustrated by Figure 3(c) which shows the wafer shape before bonding 375 and after bonding 380. The difference between these shapes is determined and translated into corresponding in-plane displacement data 385. This in-plane displacement data 385 can then be used in determining the distortion correction.

It can be appreciated that these steps only need to be performed once per reconstituted wafer regardless of the number of layers being exposed thereon. The same corrections can be applied to each layer.

The feed-forward of positional data may enable sparser metrology to be performed on the reconstituted wafer than would otherwise be necessary (unless a very high level of rework was to be accepted). As such, the displacement error correction for any displacement error described by the positional data, the placement error correction and the distortion error correction may be determined individually and combined. Alternatively, the data from each of these steps, i.e., the position specific or die specific fed-forward positional data, sparse metrology data and in-plane deformation data, can be used together (e.g., in a suitable optimization) to determine said correction for exposing each of one or more additional layers on the reconstituted wafer, the correction comprising the displacement error correction, the placement error correction and/or the distortion error correction.

The estimates of displacements of features in dies on the reconstituted wafer can be used to estimate yielding probabilities. Additionally, the described breakdown of positional errors on a reconstituted wafer into four different contributory components (as numbered 1) to 4) above is useful for monitoring and root cause analysis purposes and can help guide process improvements. A method may comprise breaking down the total top layer positional error into these components: error due to positional error on pre-diced wafer, error due to variation in location of the bonded die on the pre-diced wafer, error due to positioning of dies on base wafer during bonding and error due to in-plane deformation due to bonding induced wafer shape deformation. These components may be treated as individual key performance indicators (KPIs), from which it may be determined which of these contributors is more (or less) dominant and/or if any of these contributors becomes more (or less) dominant. This may help, for example, in determining which aspects of the overall process should be concentrated on for improvement and/or to better determine the effect of any changes to any of the contributor processes.

Because the displacements of features of each individual die is known, their intended locations on the base patterned wafer can be chosen and/or optimized to maximize likelihood of the next layer(s) being exposed within specification. This may comprise positioning the individual dies on the base wafer (e.g., selecting a die per base wafer bonding position) so as to minimize large discontinuities in positional error and/or provide for smoother, more gradual error variation across the reconstituted wafer.

Further embodiments of the invention are disclosed in the list of numbered clauses below:
1. A method of determining a correction for performing a lithographic exposure on a reconstituted substrate, said reconstituted substrate comprising a base substrate with a plurality of substrate portions bonded thereto, said substrate portions having been diced from one or more pre-diced substrates; the method comprising: obtaining positional data describing a position of features in at least an uppermost layer of said one or more pre-diced substrates; and using said positional data to determine said correction for performing the lithographic exposure on the reconstituted substrate.
2. A method according to clause 1, wherein said positional data comprises and/or is derived from overlay data from at least said uppermost layer.
3. A method according to clause 2, wherein said positional data comprises and/or is derived from alignment data for a reference layer to which said overlay data is referenced.
4. A method according to clause 3, wherein said positional data comprises a comparison and/or difference of said overlay data and alignment data.
5. A method according to any preceding clause, wherein said positional data comprises per-substrate portion positional data, describing a position of features individually for each said substrate portion.
6. A method according to clause 5, comprising tracking each said substrate portion and its corresponding positional data as measured for the substrate portion on the pre-diced substrate prior to dicing.
7. A method according to clause 5 or 6, comprising optimizing the selection and/or positioning of the individual substrate portions on said base substrate based on the per-substrate portion positional data, so as to optimize a likelihood that features exposed in said lithographic exposure are within specification.
8. A method according to clause 7, wherein said optimizing the selection and/or positioning of the individual substrate portions comprises minimizing or reducing discontinuities and/or maximizing or increasing smoothness in positional error at least partially described by the positional data across said reconstituted substrate.
9. A method according to any preceding clause, comprising obtaining reconstituted substrate alignment data measured from the reconstituted substrate, wherein said reconstituted substrate alignment data has been measured from no more than six locations per substrate portion as bonded to said reconstituted substrate.
10. A method according to clause 9, wherein said reconstituted substrate alignment data has been measured from no more than four locations per substrate portion as bonded to said reconstituted substrate.
11. A method according to clause 9, wherein said reconstituted substrate alignment data has been measured from no more than three locations per substrate portion as bonded to said reconstituted substrate.
12. A method according to clause 9, 10 or 11, wherein said locations per substrate portion measured to obtain said reconstituted substrate alignment data is varied over some or all of the substrate portions of a reconstituted substrate.
13. A method according to any of clauses 9 to 12, comprising determining a placement error correction for placement errors in bonding the substrate portions to the base substrate from said reconstituted substrate alignment data; and determining said correction for performing the lithographic exposure on the reconstituted substrate additionally from said placement error correction.
14. A method according to clause 13, wherein said placement error correction is determined from reconstituted substrate alignment data measured from only two locations per substrate portion.
15. A method according to any of clauses 9 to 14, further comprising determining a distortion correction for substrate distortion induced from bonding of said substrate portions to said base substrate from said reconstituted substrate alignment data; and determining said correction for performing the lithographic exposure on the reconstituted substrate additionally from said distortion correction.
16. A method according to clause 15, wherein said distortion correction comprises a non-linear distortion correction.
17. A method according to clause 15 or 16, comprising obtaining substrate shape data describing a change of shape of said reconstituted substrate attributable at least in part to said substrate distortion induced from bonding; and determining said distortion correction additionally from said substate shape data.
18. A method according to any preceding clause, comprising determining individual error components of positional errors on the reconstituted substrate attributable to two or more of: a positional error in the position of features in at least the uppermost layer of said one or more pre-diced substrates; variation in location of the substrate portion on the pre-diced substrate from which its diced; placement errors in bonding the substrate portions to the base substrate; and said change of shape of said reconstituted substrate induced from bonding of said substrate portions to said base substrate.
19. A method according to clause 18, comprising determining an improvement for at least one process in manufacturing the reconstituted substrate from one or more of said error components.
20. A method according to any preceding clause, further comprising determining an estimate of yield probability based on at least said positional data.
21. A method according to any preceding clause, comprising exposing each of one or more layers on said reconstituted substrate using said determined correction for performing the lithographic exposure.
22. A computer program comprising program instructions operable to perform the method of any of clauses 1 to 20, when run on a suitable apparatus.
23. A non-transient computer program carrier the computer program of clause 22.
24. A reconstituted substrate obtained by performance of the method of clause 21.
25. A processing apparatus comprising: at least one processor; and the non-transient computer program carrier of clause 23.
26. A lithographic apparatus being operable to perform the method of any of clauses 1 to 21.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and substrate optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining a correction for performing a lithographic exposure on a reconstituted substrate, said reconstituted substrate comprising a base substrate with a plurality of substrate portions bonded thereto, said substrate portions having been diced from one or more pre-diced substrates; the method comprising:
obtaining positional data describing a position of features in at least an uppermost layer of said one or more pre-diced substrates; and
using said positional data to determine said correction for performing the lithographic exposure on the reconstituted substrate.

2. A method as claimed in claim 1, wherein said positional data comprises and/or is derived from overlay data from at least said uppermost layer.

3. A method as claimed in claim 2, wherein said positional data comprises and/or is derived from alignment data for a reference layer to which said overlay data is referenced.

4. A method as claimed in claim 3, wherein said positional data comprises a comparison and/or difference of said overlay data and alignment data.

5. A method as claimed in any preceding claim, wherein said positional data comprises per-substrate portion positional data, describing a position of features individually for each said substrate portion.

6. A method as claimed in claim 5, comprising tracking each said substrate portion and its corresponding positional data as measured for the substrate portion on the pre-diced substrate prior to dicing.

7. A method as claimed in claim 5 or 6, comprising optimizing the selection and/or positioning of the individual substrate portions on said base substrate based on the per-substrate portion positional data, so as to optimize a likelihood that features exposed in said lithographic exposure are within specification.

8. A method as claimed in claim 7, wherein said optimizing the selection and/or positioning of the individual substrate portions comprises minimizing or reducing discontinuities and/or maximizing or increasing smoothness in positional error at least partially described by the positional data across said reconstituted substrate.

9. A method as claimed in any preceding claim, comprising obtaining reconstituted substrate alignment data measured from the reconstituted substrate, wherein said reconstituted substrate alignment data has been measured from no more than six locations per substrate portion as bonded to said reconstituted substrate.

10. A method as claimed in claim 9, comprising determining a placement error correction for placement errors in bonding the substrate portions to the base substrate from said reconstituted substrate alignment data; and
determining said correction for performing the lithographic exposure on the reconstituted substrate additionally from said placement error correction.

11. A method as claimed in any preceding claim, comprising determining individual error components of positional errors on the reconstituted substrate attributable to two or more of:
a positional error in the position of features in at least the uppermost layer of said one or more pre-diced substrates;
variation in location of the substrate portion on the pre-diced substrate from which its diced; placement errors in bonding the substrate portions to the base substrate; and
said change of shape of said reconstituted substrate induced from bonding of said substrate portions to said base substrate.

12. A method as claimed in any preceding claim, further comprising determining an estimate of yield probability based on at least said positional data.

13. A method as claimed in any preceding claim, comprising exposing each of one or more layers on said reconstituted substrate using said determined correction for performing the lithographic exposure.

14. A computer program comprising program instructions operable to perform the method of any of claims 1 to 13, when run on a suitable apparatus.

15. A non-transient computer program carrier the computer program of claim 14.
